**Europäisches Patentamt**

**European Patent Office**

**Office européen des brevets**

(11) Veröffentlichungsnummer: **0 410 165 A2**

(12) # EUROPÄISCHE PATENTANMELDUNG

(21) Anmeldenummer: **90112678.9**

(22) Anmeldetag: **03.07.90**

(51) Int. Cl.5: **H05K 3/00**

(30) Priorität: **27.07.89 DE 3924916**

(43) Veröffentlichungstag der Anmeldung:
**30.01.91 Patentblatt 91/05**

(84) Benannte Vertragsstaaten:
**AT DE FR GB**

(71) Anmelder: **TECHNICS PLASMA GMBH**
**Dieselstrasse 22**
**D-8011 Kirchheim bei München(DE)**

(72) Erfinder: **Naversnik, Rudolf**
**Am Gries 35**
**D-8152 Feldkirchen-Westerham(DE)**

(74) Vertreter: **Boeters, Hans Dietrich, Dr. et al**
**BOETERS & BAUER Thomas-Wimmer-Ring 14**
**14**
**D-8000 München 22(DE)**

(54) **Verfahren und Vorrichtung zur Behandlung eines Perforationen aufweisenden Objektes mit Hochfrequenzentladunsprodukten eines Plasmas.**

(57) Die Erfindung hat ein Verfahren und eine Vorrichtung zur Behandlung eines Perforationen aufweisenden Werkstücks mit Hochfrequenzentladungsprodukten eines Plasmas zum Gegenstand. Behandlungsgas wird von oben auf das im wesentlichen in einer Behandlungskammer quer angeordnete Werkstück gerichtet und unten abgesaugt. Mit der Behandlungskammer ist eine Einrichtung zur Erzeugung eines Plasmas verbunden, bei der es sich vorzugsweise um einen Mikrowellengenerator mit angeschlossenem Hohlleiter handelt.

Fig. 1

# VERFAHREN UND VORRICHTUNG ZUR BEHANDLUNG EINES PERFORATIONEN AUFWEISENDEN OBJEKTES MIT HOCHFREQUENZENTLADUNGSPRODUKTEN EINES PLASMAS

Die Erfindung bezieht sich auf ein Verfahren und eine Vorrichtung zur Behandlung eines Perforationen aufweisenden Objektes mit Hochfrequenzentladungsprodukten eines Plasmas, wobei die Vorrichtung eine Behandlungskammer mit einem Ein-und Auslaß für Behandlungsgase und eine Werkstückhalterung umfaßt.

Statt herkömmlicher chemischer Naßätzverfahren wird mehr und mehr zu Trockenätzverfahren übergegangen. Eines dieser Verfahren ist das Plasmaätzen in Hochfrequenzentladung. Hierbei werden z.B. in halogenhaltigen Medien reaktive Gasteilchen erzeugt (z.B. F-Atome), die an der Werkstückoberfläche flüchtige Verbindungen bilden. Es können gute Ätzraten realisiert werden.

In der EP-OS 0 315 986 ist eine Vorrichtung zur Erzeugung eines Plasmas beschrieben, aus dem ein Gasstrom zum Ätzen eines Werkstücks verwendet werden kann. Zur Erzeugung des Plasmas ist ein Magnetron mit angeschlossenem Hohlleiter oder einer Koaxialleitung vorgesehen, an die ein Hohlraum resonator gekoppelt ist. Im Hohlraumresonator wird das Behandlungsgas ionisiert und der zum Ätzen verwendete Plasmastrom tritt durch eine Öffnung oder Öffnungsanordnung in Richtung des Werkstücks aus.

Bei der Herstellung von Leiterplatten werden als einer der letzten Schritte Löcher für Montagezwecke gebohrt. Hierbei entstehen Materialspäne und -verschmierungen, die zu einer unerwünschten Leiterplattenverschmutzung führen können, sofern nicht das überschüssige Material entfernt wird.

Der Erfindung liegt die Aufgabe zugrunde, ein Verfahren und einer Vorrichtung zur Behandlung eines Perforationen aufweisenden Werkstücks mit Hochfrequenzentladungsprodukten eines Plasmas anzugeben, die eine hohe Ätzgeschwindigkeit ermöglichen.

Diese Aufgabe ist erfindungsgemäß bei einem Verfahren und einer Vorrichtung mit den Merkmalen des Anspruchs 1 bzw. 6 gelöst. Vorteilhafte Weiterbildungen des erfindungsgemäßen Verfahrens und der Vorrichtung sind Gegenstand der Unteransprüche.

Das erfindungsgemäße Verfahren zur Behandlung eine's Perforationen aufweisenden Werkstücks mit Hochfrequenentladungsprodukten eines Plasmas ist dadurch gekennzeichnet, daß Behandlungsgas von oben auf das im wesentlichen quer angeordnete Werkstück gerichtet und unten abgesaugt wird. Die Durchflußmengen liegen bei etwa 10 bis 1000 sccm .

Bei der erfindungsgemäßen Gasstrahlführung wird erreicht, daß die aktiven Gaspartikel im wesentlichen senkrecht auf die Werkstückoberfläche auftreffen. Anschließend werden die Gasteilchen durch die Perforationen des Werkstücks, z.B. Bohrungen einer Leiterplatte, von oben nach unten abgesaugt. Hierdurch erfolgt eine außerordentlich schnelle und gleich mäßige Reinigung der Bohrlöcher und die mit dem erfindungsgemäßen Verfahren erzielbare Ätzgeschwindigkeit ist ein Vielfaches der Ätzgeschwindigkeiten, die mit herkömmlichen Plasma-Desmearing-Anlagen erzielbar sind.

Die Bezugnahme auf oben und unten ist lediglich beispielhaft. Selbstverständlich kann das Werkstück umgekehrt oder auch so orientiert sein, daß seine Bearbeitungsoberfläche im wesentlichen aufrecht steht, wobei der Gasstrom von links nach rechts oder umgekehrt erfolgt. Es können auch mehrere Werkstücke zugleich behandelt werden, wobei die Behandlung nicht nur auf Ätz- und Reinigungsvorgänge beschränkt ist, sondern auch zu Aktivierungszwecken der Oberfläche von Kunsttoffteilen vorgesehen sein kann. Das erfindungsgemäße Verfahren eignet sich besonders für plattenförmige Werkstücke bzw. Werkstücke mit einem eine gewisse Erstreckung aufweisenden Querschnitt im Gasstrom.

Das erfindungsgemäße Verfahren ist vorzugsweise so ausgestaltet, daß das Plasma in einer das (die) Werkstück(e) enthaltenden Behandlungskammer erzeugt wird. Der Wirkungsgrad der Plasmaerzeugung ist daher besonders günstig und der Aufbau einer Vorrichtung zur Anwendung des Verfahrens vereinfacht.

Als Behandlungsgase werden einzelne Gase oder Gaskombinationen in verschiedensten Mischungsverhältnissen verwendet. Beispiele für Gase sind $O_2$, $CF_4$, $N_2$ sowie Edelgase. Die im Plasma enthaltenen aktiven Gasteilchen (Ionen, Radikale und sonstige Verbindungen) bewirken eine Oxidation sämtlicher organischen Stoffe (Leiterplattenmaterial besteht z.B. aus Phenol, Epoxid-, Melamin-, Siliconharz, Polyester, Teflon, Polyimid, Acrylkleber, etc. ) zu gasförmigen Verbindungen, z.B. $CO_2$ und $H_2O$. Die Reaktionsprodukte werden zusammen mit dem Plasmagas abgesaugt.

Das Plasma wird vorzugsweise durch Mikrowellen erzeugt, zweckmäßig mit einer Frequenz von etwa 2,45 GHz und einer Leistung im Bereich von

sccm = Standard-cm³/min

etwa 100 bis 2500 Watt. Hochfrequente Wellen in diesem Wellenlängenbereich lassen sich einfach in eine Behandlungskammer einkoppeln, in der das Plasma dann gezündet werden kann.

Eine erfindungsgemäße Vorrichtung zur Behandlung eines Perforationen aufweisenden Werkstücks mit Hochfrequenzentladungsprodukten eines Plasmas umfaßt eine Behandlungskammer mit einem Ein- und Auslaß für Behandlungsgase und eine Werkstückhalterung sowie eine Aufnahme für das Werkstück, wobei der Einlaß für Behandlungsgase auf einer Seite des Werkstücks und der Auslaß auf dessen anderer Seite angeordnet ist und das Werkstück quer zur Bewegungsrichtung der Behandlungsgase angeordnet ist. Eine Vakuumpumpe ist an den Auslaß angeschlossen und ferner ist eine Einrichtung zur Erzeugung eines Plasmas mit der Behandlungskammer verbunden. Eine so aufgebaute Vorrichtung eignet sich besonders zur Anwendung des erfindungsgemäßen Verfahrens.

Vorzugsweise sind mehrere Einlässe und/oder Auslässe für die Behandlungsgase vorgesehen. Auf diese Weise können die Behandlungsgase gleichmäßiger über die Werkstückoberfläche verteilt werden, so daß der Ätzvorgang insgesamt gleichmäßiger ablaufen kann.

Insbesondere zur Behandlung plattenförmiger Werkstücke ist die Werkstückaufnahme bevorzugt in einem herausziehbaren, horizontalen Einschub befestigt, wobei die Ein- und Auslässe für die Behandlungsgase oben bzw. unten in der Wandung der Behandlungskammer angeordnet sind. Selbstverständlich ist diese Anordnung nicht auf eine vertikale Anordnung beschränkt. Es können unter Umständen auch mehrere herausziehbare Einschübe innerhalb eines Schubladensystems vorgesehen sein. Sie ermöglichen eine einfache und rasche Anbringung der zu behandelnden Werkstücke außerhalb der Apparatur. Nach der Anbringung brauchen die Schubladen lediglich eingeschoben zu werden. Zweckmäßig ist in den Einschüben ein Aufnahmerahmen angebracht, auf den die Werkstücke im Fall von Leiterplatten beispielsweise lediglich aufgelegt zu werden brauchen.

Die Einrichtung zur Erzeugung eines Plasmas umfaßt bei einem bevorzugten Ausführungsbeispiel der Erfindung einen oder mehrere Mikrowellengeneratoren, die vorteilhaft über einen oder mehrere Hohlleiter mit der Behandlungskammer verbunden sind. Die Hohlleiter sind zweckmäßig vom R32-Typ und über einen Flansch und durch O-Ring abgedichtete Quarzglasscheiben mit der Behandlungskammer verbunden. Die Mikrowellenleistung wird über die Hohlleiter und Quarzglasscheiben aus dem Mikrowellengenerator in das in der Behandlungskammer enthaltene Behandlungsgas eingekoppelt.

Zur Plasmabehandlung eines Werkstücks wird dieses somit erfindungsgemäß zunächst auf einer Aufnahme angeordnet und in die Behandlungskammer eingebracht. Anschließend erfolgt eine Evakuierung der Behandlungskammer, in die dann Behandlungsgas eingeführt wird. Eine Zündung eines Plasmas im Behandlungsgas erfolgt durch Einschalten des Mikrowellengenerators. Durch die dann erfolgende Absaugung des Behandlungsgases und der Reaktionsprodukte werden die Plasmagasstrahlen wirksam an den zu behandelnden Werkstückstellen vorbeigeführt und können mit diesen in Wechselwirkung treten. Die gasförmigen Reaktionsprodukte werden zusammen mit dem Behandlungsgas abgesaugt.

Die Erfindung wird im folgenden weiter anhand eines bevorzugten Ausführungsbeispiels und der Zeichnung erläutert. In der Zeichnung zeigen:

Fig. 1 eine perspektivische Ansicht einer Apparatur, in der eine erfindungsgemäße Vorrichtung eingebaut ist,

Fig. 2 eine perspektivische Ansicht einer erfindungsgemäßen Vorrichtung und

Fig. 3 eine Schnittansicht der Vorrichtung von Fig. 2.

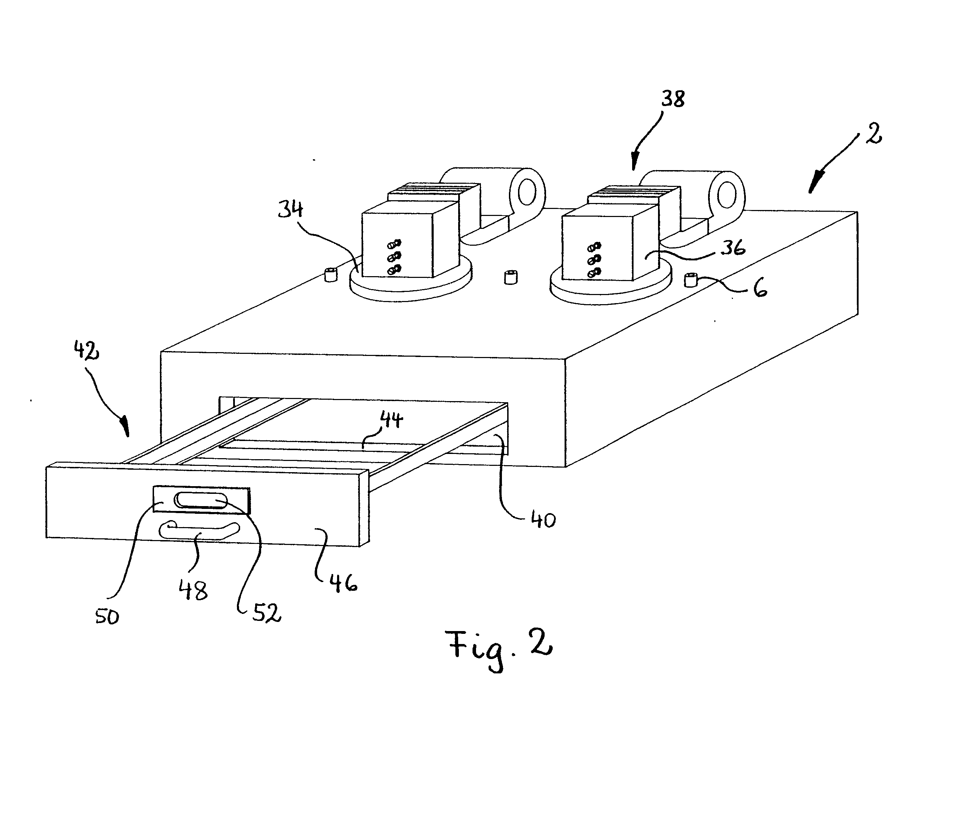

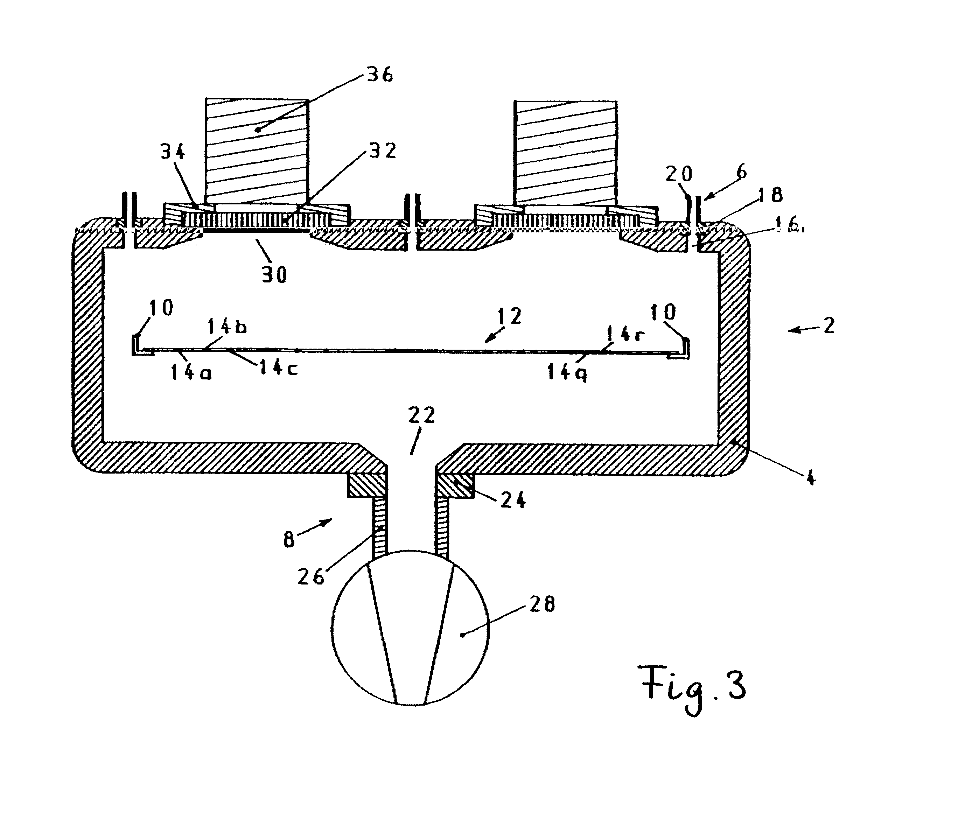

Es wird zunächst auf Fig. 2 und 3 Bezug genommen, in denen ein Ausführungsbeispiel einer erfindungsgemäßen Vorrichtung dargestellt ist.

Eine Behandlungskammer 2 umfaßt eine Wandung 4, die auf der Oberseite drei Einlässe 6 für Behandlungsgas und einen zentralen Auslaß 8 für Gase aufweist. Im Inneren der Behandlungskammer 2 befindet sich ein Aufnahmerahmen 10, auf dem ein zu behandelndes Werkstück 12 befestigt ist. Bei dem Werkstück 12 handelt es sich im gezeigten Ausführungsbeispiel um eine Leiterplatte. Die Leiterplatte ist mit einer Anzahl von Bohrungen 14a, 14b, 14c, ... 14q, 14r versehen. Bei Anordnung des Werkstücks 12 im Inneren der Behandlungskammer 2, d.h. im Behandlungsraum, weisen die Bohrungen 14 Verschmierungen auf, die durch die Behandlung entfernt werden sollen.

Die Einlässe 6 sind jeweils durch eine Bohrung 16 in der Wandung 4 der Behandlungskammer 2 gebildet. In einen erweiterten äußeren Abschnitt 18 der Bohrungen 16 sind Anschlußstutzen 20 eingesetzt. An diese können auf übliche Weise Gasleitungen angeschlossen werden.

Der Auslaß 8 ist durch einen erweiterten Kanal 22 im Bodenteil der Wandung 4 gebildet, an dem außen ein Anschluß 24 sitzt. Über eine schematisch angedeutete Leitung 26 ist eine Vakuumpumpe 28 angeschlossen.

Oben in der Wandung 4 ist diese zwischen den Einlässen 6 mit zwei größeren Öffnungen 30 versehen. Die Öffnungen 30 sind durch Quarzglasscheiben 32 und nicht dargestellte O-Ringe abgedichtet verschlossen. Nach außen hin sind die Quarzglasscheiben 32 jeweils in einen Flansch 34 eingebettet. Auf dem Flansch 34 sitzt ein Hohlleiter 36 mit angeschlossenem Mikrowellengenerator 38, der herkömmlich aufgebaut ist.

Auf der Vorderseite weist die Behandlungskammer 2 eine rechteckförmige Öffnung 40 auf, durch die sich ein herausziehbarer, horizontaler Einschub 42 ähnlich einer Schublade erstreckt. Seitlich weist der Einschub 42 jeweils den Aufnahmerahmen 10 bildende Winkelstäbe auf. Zusätzlich können für kleinere Leiterplattenformate mit Aussparungen versehene Adapterbleche verwendet werden, die in den Aufnahmerahmen eingelegt werden. Auf der Vorderseite ist der Einschub 42 mit einer Abdeckplatte 46 versehen. An der Abdeckplatte 46 sind ein Griff 48 und eine Befestigungsplatte 50 für ein Schauglas 52 angebracht. Der Einschub 42 ist in Fig. 2 in etwas herausgeschobener Stellung gezeigt. Zum Verschließen ist lediglich erforderlich, ihn zur Behandlungskammer hin zu drücken, wobei er durch nicht dargestellte Federn und eine Klemmpassung mit Abdichtung vakuumdicht fixiert werden kann.

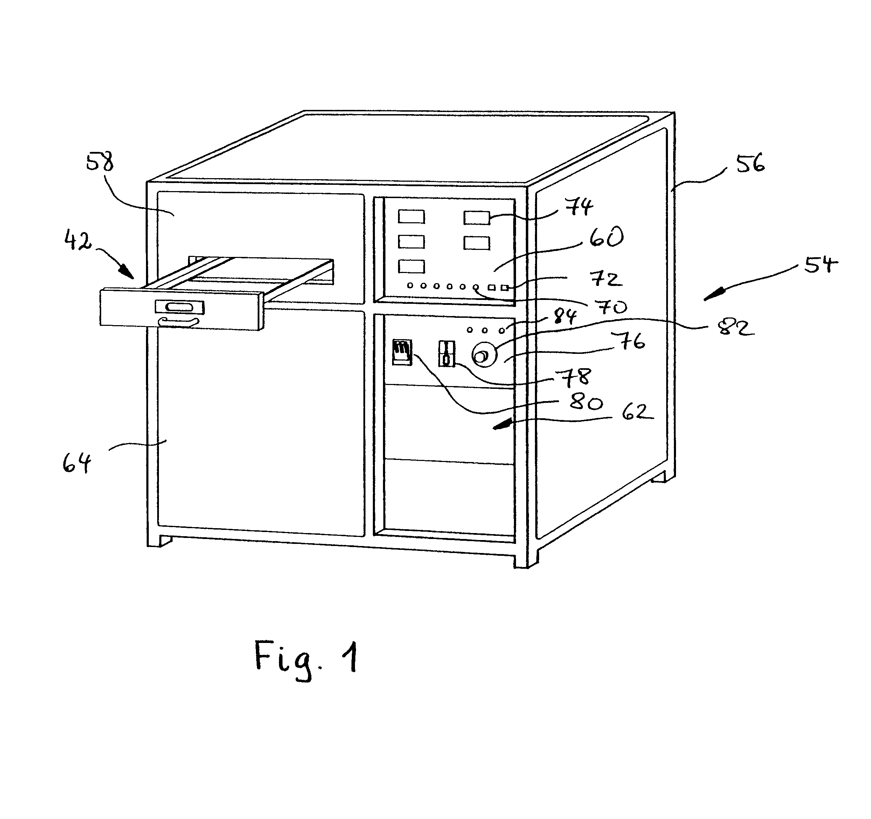

Die anhand von Fig. 2 und 3 erläuterte Behandlungskammer 2 ist in einer in Fig. 1 dargestellten Apparatur 54 eingebaut. Das Rahmengestell 56 der Apparatur 34 ist auf der Vorderseite in vier Bereiche 58, 60, 62 und 64 aufgeteilt. Der Bereich 58 umfaßt eine Abdeckung derart, daß die gesamte Behandlungskammer 2 mit Aufbau einschließlich Mikrowellengenerator abgedeckt sind, die in diesem Bereich angeordnet sind. Rechts vom Bereich 58, d.h. im Bereich 60, befinden sich Steuereinheiten, deren zugehörige Bedienungstasten 70, 72 und Funktionsanzeigen 74 dargestellt sind. Im darunter befindlichen Bereich 62 befinden sich Leistungseinheiten, wo bei im obersten Einschub 76 der Ein/Ausschalter 78, Schalter 80 für die Vakuumpumpe 28 und ein Einstellpotentiometer 82 für die Mikrowellenleistung und weitere Bedienungstasten 84 angeordnet sind.

Die dargestellte Apparatur ist zur Beseitigung von Bohrverschmierungen in Leiterplatten und zur Oberflächenaktivierung von Kunststoffteilen im Niederdruckplasma geeignet. Grundsätzlich sind auch andere Oberflächenbehandlungen möglich. Eine weitere Anwendung ist die Sterilisation im Hygienebereich und von medizinischen Geräten.

**Ansprüche**

1. Verfahren zur Behandlung eines Perforationen aufweisenden Werkstücks mit Hochfrequenzentladungsprodukten eines Plasmas, dadurch **gekennzeichnet,** daß Behandlungsgas von oben auf das im wesentlichen quer angeordnete Werkstück gerichtet und unten abgesaugt wird.

2. Verfahren nach Anspruch 1, dadurch **gekenn-**

zeichnet, daß das Plasma in einer das (die) Werkstück(e) enthaltenden Behandlungskammer erzeugt wird.

3. Verfahren nach Anspruch 1 oder 2, dadurch **gekennzeichnet,** daß als Behandlungsgase $O_2$, $CF_4$, $N_2$ sowie Edelgase verwendet werden.

4. Verfahren nach einem der Ansprüche 1 bis 3, dadurch **gekennzeichnet,** daß das Plasma durch Mikrowellen erzeugt wird.

5. Verfahren nach einem der Ansprüche 1 bis 4 , dadurch **gekennzeichnet,** daß Mikrowellen mit einer Frequenz von etwa 2,45 GHz verwendet werden.

6. Vorrichtung zur Behandlung eines Perforationen aufweisenden Werkstücks mit Hochfrequenzentladungsprodukten eines Plasmas, umfassend eine Behandlungskammer mit einem Ein- und Auslaß für Behandlungsgase und eine Werkstückhalterung, und insbesondere zur Durchführung des Verfahrens nach einem der Ansprüche 1 bis 5, dadurch **gekennzeichnet,** daß

- eine Aufnahme (10) für das Werkstück (12) vorgesehen ist,

- der Einlaß (6) für Behandlungsgase auf einer Seite des Werkstücks (12) und der Auslaß (8) auf dessen anderer Seite angeordnet ist, wobei das Werkstück quer zur Bewegungsrichtung der Behandlungsgase angeordnet ist,

- eine Vakuumpumpe (28) an den Auslaß (8) angeschlossen ist und

- eine Einrichtung (38) zur Erzeugung eines Plasmas mit der Behandlungskammer (2) verbunden ist.

7. Vorrichtung nach Anspruch 6, **gekennzeichnet** durch mehrere Einlässe (6) und/oder Auslässe (8) für die Behandlungsgase.

8. Vorrichtung nach einem der Ansprüche 6 oder 7, zur Behandlung plattenförmiger Werkstücke, dadurch **gekennzeichnet,** daß die Aufnahme (10) in einem herausziehbaren, horizontalen Einschub (42) befestigt ist, wobei die Ein- und Auslässe (6, 8) für die Behandlungsgase oben bzw. unten in der Wandung (4) der Behandlungskammer (2) angeordnet sind.

9. Vorrichtung nach einem der Ansprüche 6 bis 8, dadurch **gekennzeichnet,** daß die Einrichtung (38) zur Erzeugung eines Plasmas einen oder mehrere Mikrowellengeneratoren umfaßt.

10. Vorrichtung nach Anspruch 9, dadurch **gekennzeichnet,** daß der (die) Mikrowellengenerator(en) (38) über einen oder mehrere Hohlleiter (36) mit der Behandlungskammer (2) verbunden ist (sind).

11. Vorrichtung nach einem der Ansprüche 9 oder 10, dadurch **gekennzeichnet,** daß die Verbindung Hohlleiter/Behandlungskammer einen Flansch (34) und Quarzglasscheiben (32) umfaßt.

Fig. 1

EP 0 410 165 A2

Fig. 2

Fig.3

EP 0 410 165 A2